# EUROPEAN PATENT SPECIFICATION

(11) **EP 3 361 850 B1**
(45) Date of publication and mention of the grant of the patent: **22.03.2023**
(21) Application number: 17155183.1
(22) Date of filing: 08.02.2017
(51) Int. Cl.: H05K 9/00, H05K 7/14

(54) **COMBINATION OF A HOUSING FOR AN ELECTRONIC DEVICE AND AN ACCOMMODATION FOR THE HOUSING**
KOMBINATION EINES GEHÄUSES FÜR EIN ELEKTRONISCHES GERÄT UND EINER AUFNAHME FÜR DAS GEHÄUSE
COMBINAISON D'UN BOITIER POUR UN DISPOSITIF ÉLECTRONIQUE ET UN LOGEMENT POUR LE BOITIER

(43) Date of publication of application: 15.08.2018
(73) Proprietor: Rohde & Schwarz GmbH & Co. KG, 81671 München (DE)
(72) Inventor: Goeritz, Raimon, 10779 Berlin (DE); Fehse, Dirk, 12524 Berlin (DE)
(74) Representative: Prinz & Partner mbB

(56) References cited:
- DE-U1-202006 010 381
- JP-A- H0 946 262
- US-A- 4 008 942
- US-B1- 6 464 085
- US-B1- 6 483 023
- US-B1- 7 016 201
- "STORAGE RECEPTACLE SLOT WITH BIASED RETAINER SPRING", IBM TECHNICAL DISCLOSURE BULLETIN, INTERNATIONAL BUSINESS MACHINES CORP. (THORNWOOD), US, vol. 38, no. 12, 1 December 1995 (1995-12-01), pages 169-172, XP000588101, ISSN: 0018-8689

## Description

The invention relates to a combination of a housing for an electronic device, in particular an amplifier housing, and an accommodation for the housing.

Amplifiers and in particular the output stage of amplifiers usually comprise many different types of housings which each is mounted in its accommodation (for example a rack) in a very particular manner. Accordingly, the user of the amplifier has to have particular tools for replacing the amplifier when necessary, or it is necessary that a service technician is called for replacing the amplifier.

US 6,464,085 B1 describes a CD-ROM rack including a rack body adapted to support computer readable disk drivers, the rack body having transverse sliding tracks at two opposite side panels thereof, a plurality of retaining spring plates respectively riveted to the side panels of the rack body and adapted for locking loaded computer readable disk drivers, and a plurality of elongated holding down plates respectively inserted into the transverse sliding tracks to hold down the retaining spring plates in the locking position.

US 7,016,201 B1 refers to a drawer equipped with electronic cards, wherein resilient means for establishing electrical connection are provided.

US 4,008,942 refers to holding and support means for a printed circuit board. The holding or support means are fabricated of spring steel and are supported at one end by the same fastening means than fastens the printed circuit board connector to its mounting surface.

US 6,486,023 B1 describes metal spring gaskets for EMI shielding in linecard plug-in units.

DE 20 2006 010 381 U1 discloses a disk drive mounted in a drive slot. The disk drive is fixed in the drive slot by means of an elastic holder which is fixed to the drive slot and releasable engages the disk drive.

"Storage Receptacle slot with biased Retainer spring", IBM Technical disclosure bulletin, international business machines corp. (Thornwood), US, vol.38, no. 12, 1 December 1995, pages 169-172, XP000588101, discloses a cartridge storage slot using leaf springs to retain the cartridge inside the slot.

JP H09 46262 A discloses a portable electronic apparatus housing comprising a spring piece with a projection at its tip capable of engaging a portable electronic device. The force of the spring prevents the portable electronic device from falling off from the housing.

The object of the invention is to make it easier to replace the electronic device, in particular the amplifier.

To this end, the invention provides for a combination of a housing for an electronic device and an accommodation for the housing, wherein a latching spring comprising a spring arm and a latching end is provided at the accommodation, wherein the accommodation comprises two rails, the spring arm being connected to one of the rails and the latching end extending through a window in the rail, the latching spring engaging at the housing when the housing is in a mounted position by being pushed into place into the accommodation, wherein the latching end engages into a cut-out provided in the housing. The latching spring automatically latches the housing in the mounted position. The housing comprises an opening in a front surface through which the latching spring is accessible so as to release the latching end from the cut-out. The invention is based on the idea of using a universal type of attachment for the housing of the electronic device which can be released easily without the need of special tools or a service technician. Thus, it is very simple to replace the electronic device, in particular the amplifier, when this is necessary. The opening allows a user to very conveniently access the latching spring such that it can be pushed into a position in which the housing can be withdrawn from the accommodation.

By means of the latching spring automatically latching the housing in the mounted position, it is ensured that the electronic device is reliably secured in the accommodation simply by pushing it into place into the accommodation. No additional steps such as tightening of a screw or moving a clamping element into a clamping position are necessary.

According to a preferred embodiment, the latching spring establishes a ground connection for the electronic device. It is thus not necessary to additionally connect a ground cable to the electronic device.

According to an embodiment of the invention, at least one additional spring is provided for establishing a ground connection for the electronic device. Using an additional spring or, if necessary, a plurality of additional springs arranged at a distance from each other along a longitudinal edge of the housing, increases the reliability with which the ground connection is automatically established when the housing is being inserted into the accommodation.

Preferably, the additional spring is of the same type as the latching spring, thereby reducing the number of additional parts necessary for manufacturing the accommodation for the housing.

By means of the latching spring comprising a spring arm and a latching end, the spring arm very conveniently provides the required resiliency so that the latching end can be displaced between a latching position in which it engages at the housing, and a release position in which the housing can be withdrawn from the accommodation or mounted in the accommodation.

Due to the accommodation comprising two rails, the spring arm being connected to one of the rails, the number of necessary parts for manufacturing the accommodation is reduced. Further, any forces transmitted to the spring for retaining the housing in the accommodation are directly transferred into the rails.

The latching end engaging into a recess provided in the housing results in a very simple design of the entire mechanism for latching the housing in the accommodation.

Since the latching end extends through a window in the rail, the spring can be connected to a side of the rail which is opposite the side which receives the housing, thereby guarantying that the rail provides a smooth guiding path for the housing.

According to a preferred embodiment, the housing comprises at least a chamfer at a rear side. The chamfer facilitates insertion of the housing into the accommodation in that it smoothly presses the latching spring outwardly such that no actuation of the spring is necessary for being able to mount the housing in the accommodation.

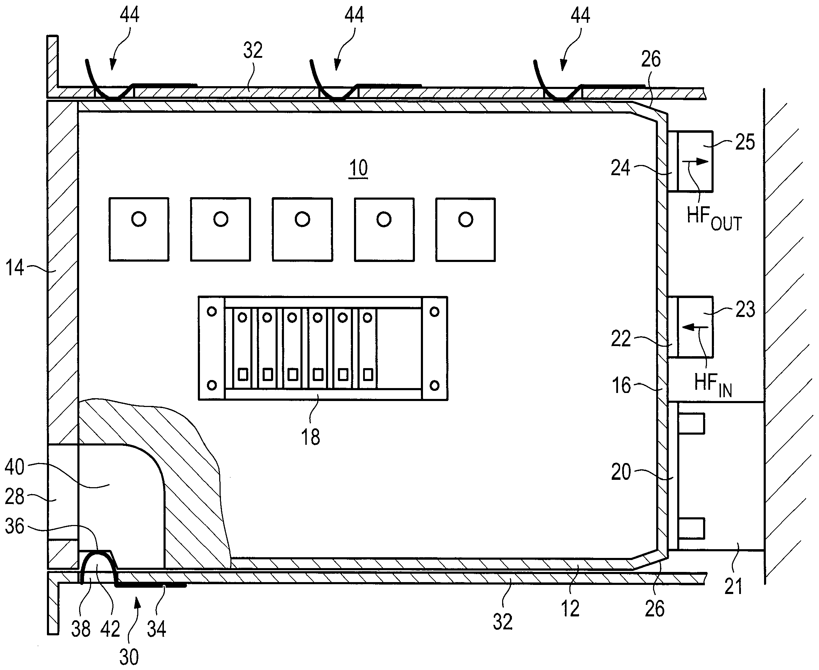

The invention will now be described with reference to the enclosed drawing in which a cross section through an embodiment of the invention is shown.

In the drawing, an electronic device 10 is schematically shown which here is an amplifier, in particular the output stage of an amplifier. The electronic device can also be an industrial personal computer, a storage means, an oscilloscope, a vector network analyzer or a similar device.

Electronic device 10 has an outer housing 12 which has a front surface 14 and a rear side 16.

Within housing 12, certain electronic components 18 are arranged.

At the rear side 16 of housing 12, various plug connectors 20, 22, 24 are arranged. As an example, plug connector 20 is a control connector which comprises guiding pins. Plug connector 22 is a high frequency input, and the plug connector 24 is a high frequency output.

At the transition from the rear side 16 to the lateral walls of housing 12, a chamfer 26 is provided at each side.

In the front surface 14 of housing 12, an opening 28 is provided through which an operator can reach a latching spring 30.

Housing 12 is received in an accommodation which generally speaking is the slot in which housing 12 is arranged. The accommodation comprises at each side a guide rail 32 which typically is formed from a metal.

Latching spring 30 comprises a spring arm 34 and a latching end 36. Spring arm 34 extends straight over a certain distance while latching end 36 is curved. In the shown embodiment, latching end 36 extends over more than 90°.

Latching spring 30 is mounted at one of the rails 32 such that spring arm 34 extends along the guide rail while latching end 36 extends through a window 38 provided in rail 32 into a hollow space 40 provided behind opening 28. Latching end 36 is accessible within that area but engages at the edges of a cutout 42 provided in housing 12.

Latching spring 30 can be connected to rail 32 by welding or otherwise connecting the free end of spring arm 34 to rail 32.

The connection between rail 32 and latching spring 30 is electrically conducting. Thus, latching spring 30 forms a ground connection for housing 12.

In order to improve the ground connection, additional similar springs can be provided on the same rail or on the opposite rail. As shown in Figure, three additional springs 44 are provided which each extend through a window 38 in rail 32 so as to slidingly engage on the outside of housing 12.

Housing 12 is mounted in the accommodation by inserting it into the space between the rails 32. This is facilitated by the chamfers 26. The respective chamfer 26 also assists in pushing latching spring 30 (or the springs 44) outwardly when the rear side is inserted.

During the process of insertion, springs 44 slide along the outside of the housing. At the end of the insertion process, the plug connectors 20, 22, 24 engage into their counter parts 21, 23, 25. Further, latching end 36 of latching spring 30 engages into cutout 42 so as to mechanically latch the electronic device 10 in its accommodation. The electronic device 10 is thus reliably held in the accommodation.

For removing electronic device 10 from the accommodation, a user can very conveniently press with his finger onto latching end 36 of latching spring 30 so as to release the latching end 36 from the cutout 42. Then, electronic device 10 can be withdrawn from the accommodation, thereby disconnecting plug connectors 20, 22, 24 from their counter parts.

## Claims

1. A combination of a housing (12) for an electronic device (10), in particular an amplifier housing, and an accommodation (32) for the housing, wherein a latching spring (30) comprising a spring arm (34) and a latching end (36) is provided at the accommodation (32), wherein the accommodation comprises two rails (32), the spring arm (34) being connected to one of the rails (32) and the latching end (36) extending through a window in the rail (32), the latching spring (30) engaging at the housing (12) when the housing (12) is in a mounted position by being pushed into place into the accommodation, wherein the latching end (36) engages into a cut-out (42) provided in the housing (12) and the latching spring (30) automatically latches the housing (12) in the mounted position, **characterized in that** the housing (12) comprises an opening (28) in a front surface (14) through which the latching spring (30) is accessible so as to release the latching end (36) from the cut-out (42).

2. The combination of claim 1, **characterized in that** the latching spring (30) establishes a ground connection for the electronic device (10).

3. The combination of any of the preceding claims, **characterized in that** at least one additional spring (44) is provided for establishing a ground connection for the electronic device (10).

4. The combination of claim 3, **characterized in that** the additional spring (44) is of the same type as the latching spring (30).

5. The combination of claim 3 or claim 4, **characterized in that** a plurality of additional springs (44) is provided, the springs (44) being arranged along a longitudinal edge of the housing (10).

6. The combination of any of the preceding clams, **characterized in that** the housing (12) comprises a chamfer (26) at a rear side.

## Patentansprüche

1. Kombination aus einem Gehäuse (12) für eine elektronische Vorrichtung (10), insbesondere einem Verstärkergehäuse, und einer Umschließung (32) für das Gehäuse, wobei eine Rastfeder (30) einen Federarm (34) umfasst und ein Rastende (36) an der Umschließung (32) vorgesehen ist, wobei die Umschließung zwei Schienen (32) umfasst, wobei der Federarm (34) mit einer der Schienen (32) verbunden ist und wobei sich das Rastende (36) durch ein Fenster in der Schiene (32) erstreckt, wobei die Rastfeder (30) in das Gehäuse (12) eingreift, wenn sich das Gehäuse (12) durch Drücken an seinen Platz in der Umschließung in einer montierten Position befindet, wobei das Rastende (36) in einen im Gehäuse (12) vorgesehenen Ausschnitt (42) eingreift und die Rastfeder (30) in der montierten Position automatisch am Gehäuse (12) einrastet, **dadurch gekennzeichnet, dass** das Gehäuse (12) eine Öffnung (28) in einer Vorderfläche (14) umfasst, durch die die Rastfeder (30) zugänglich ist, um das Rastende (36) aus dem Ausschnitt (42) zu lösen.

2. Kombination nach Anspruch 1, **dadurch gekennzeichnet, dass** die Rastfeder (30) eine Masseverbindung für die elektronische Vorrichtung (10) herstellt.

3. Kombination nach einem der vorhergehenden Ansprüche, **dadurch gekennzeichnet, dass** mindestens eine zusätzliche Feder (44) zum Herstellen einer Masseverbindung für die elektronische Vorrichtung (10) vorgesehen ist.

4. Kombination nach Anspruch 3, **dadurch gekennzeichnet, dass** die zusätzliche Feder (44) vom selben Typ ist wie die Rastfeder (30).

5. Kombination nach Anspruch 3 oder 4, **dadurch gekennzeichnet, dass** eine Vielzahl von zusätzlichen Federn (44) vorgesehen ist, wobei die Federn (44) entlang einer Längskante des Gehäuses (10) angeordnet sind.

6. Kombination nach einem der vorhergehenden Ansprüche, **dadurch gekennzeichnet, dass** das Gehäuse (12) an einer Rückseite eine Abschrägung (26) umfasst.

## Revendications

1. Combinaison composée d'un boîtier (12) pour un dispositif électronique (10), en particulier, un boîtier d'amplificateur, et d'un logement (32) pour le boîtier, dans laquelle un ressort de verrouillage (30) comprenant un bras de ressort (34) et une extrémité de verrouillage (36), est prévu au niveau du logement (32), dans laquelle le logement comprend deux rails (32), le bras de ressort (34) étant raccordé à l'un des rails (32) et l'extrémité de verrouillage (36) s'étendant à travers une fenêtre dans le rail (32), le ressort de verrouillage (30) se mettant en prise au niveau du boîtier (12) lorsque le boîtier (12) est dans une position montée en étant poussé en place dans le logement, dans laquelle l'extrémité de verrouillage (36) se met en prise dans une découpe (42) prévue dans le boîtier (12) et le ressort de verrouillage (30) verrouille automatiquement le boîtier (12) dans la position montée, **caractérisée en ce que** le boîtier (12) comprend une ouverture (28) dans une surface avant (14) à travers laquelle le ressort de verrouillage (30) est accessible afin de libérer l'extrémité de verrouillage (36) de la découpe (42).

2. Combinaison selon la revendication 1, **caractérisée en ce que** le ressort de verrouillage (30) établit une connexion de terre pour le dispositif électronique (10).

3. Combinaison selon l'une quelconque des revendications précédentes, **caractérisé en ce qu'**au moins un ressort supplémentaire (44) est prévu pour établir une connexion de terre pour le dispositif électronique (10).

4. Combinaison selon la revendication 3, **caractérisée en ce que** le ressort supplémentaire (44) est du même type que le ressort de verrouillage (30).

5. Combinaison selon la revendication 3 ou la revendication 4, **caractérisée en ce qu'**une pluralité de ressorts supplémentaires (44) est prévue, les ressorts (44) étant agencés le long d'un bord longitudinal du boîtier (10).

6. Combinaison selon l'une quelconque des revendications précédentes, **caractérisée en ce que** le boîtier (12) comprend un chanfrein (26) au niveau d'un côté arrière.
